# EUROPEAN PATENT APPLICATION

(11) **EP 3 402 312 A1**
(43) Date of publication of application: **14.11.2018**
(21) Application number: 16883678.1
(22) Date of filing: 31.10.2016
(51) Int. Cl.: H05B 33/06, F21S 2/00, F21V 19/00, H01L 51/50, H05B 33/10, F21Y 115/20

(54) **MOTHER BOARD, AND METHOD FOR MANUFACTURING LIGHTING DEVICE**

(30) Priority: 05.01.2016 JP 2016000641
(71) Applicant: SUMITOMO CHEMICAL COMPANY, LIMITED, Chuo-ku Tokyo 104-8260 (JP)
(72) Inventor: FURIHATA, Masatoshi, Niihama-shi Ehime 792-0015 (JP)
(74) Representative: J A Kemp
(86) International application number: PCT/JP2016/082265
(87) International publication number: WO 2017/119178

(57) **Abstract**

A mother board includes a plurality of organic EL elements, each of the plurality of organic EL elements has a configuration in which a first electrode layer, an organic functional layer, and a second electrode layer are sequentially stacked on a rectangular support substrate, each of the plurality of organic EL elements includes a first positive electrode terminal and a second positive electrode terminal that are electrically connected to the first electrode layer and a first negative electrode terminal and a second negative electrode terminal that are electrically connected to the second electrode layer, neighboring organic EL elements are arranged so that the first positive electrode terminal or the second positive electrode terminal and the first negative electrode terminal or the second negative electrode terminal face each other, and predetermined ones of the first positive electrode terminals or the second positive electrode terminals and the first negative electrode terminals or the second negative electrode terminals are electrically connected to each other by a connecting member so that the plurality of organic EL elements constitute a lighting unit.

## Description

### Technical Field

The invention relates to a mother board and a method of manufacturing a lighting device.

### Background Art

Patent Literature 1 discloses a lighting device including a lighting unit in which a plurality of light emitting elements are electrically connected.

### Citation List

### Patent Literature

Patent Literature 1: Japanese Unexamined Patent Application Publication No. 2007-173564

### Summary of Invention

### Technical Problem

However, when a plurality of light emitting elements are connected to constitute a lighting unit as in the above-mentioned lighting device, it is necessary to arrange a plurality of light emitting elements and to electrically connect neighboring light emitting elements. Accordingly, there is a problem in that labor is required for constructing a lighting unit.

Therefore, an aspect of the invention provides a mother board and a method of manufacturing a lighting device that can enable a lighting unit to be easily obtained.

### Solution to Problem

A mother board according to an aspect of the invention is a mother board including a plurality of organic EL elements, wherein each of the plurality of organic EL elements has a configuration in which a first electrode layer, an organic functional layer, and a second electrode layer are sequentially stacked on a rectangular support substrate having a first side and a second side extending to be substantially parallel to each other and a third side and a fourth side extending to be substantially parallel to each other, wherein each of the plurality of organic EL elements includes a first terminal that is electrically connected to the first electrode layer and a second terminal that is electrically connected to the second electrode layer, wherein neighboring organic EL elements are arranged so that the first terminal and the second terminal face each other, and wherein predetermined ones of the first terminals and the second terminals are electrically connected to each other by a connecting member so that the plurality of organic EL elements constitute a lighting unit.

In the mother board according to the aspect of the invention, neighboring organic EL elements are arranged so that the first terminal and the second terminal face each other. In this configuration, predetermined ones of the first terminal and the second terminal are electrically connected by a connecting member so that the plurality of organic EL elements constitute a lighting unit. In this way, since a lighting unit is constituted in advance in the mother board, it is possible to obtain the lighting unit by cutting the mother board. Accordingly, since an operation of connecting the plurality of organic EL elements does not need to be performed, it is possible to easily obtain a lighting unit.

In the embodiment, the first terminal may be disposed close to the first side and the second terminal may be disposed close to the second side. According to this configuration, neighboring organic EL elements can be arranged so that the first terminal and the second terminal face each other.

In the embodiment, the first terminal may be disposed close to the third side and the fourth side, the second terminal may be disposed close to the third side and the fourth side, and the first terminal and the second terminal may be disposed to face each other in a direction in which the third side and the fourth side extend at positions close to the third side and the fourth side. According to this configuration, neighboring organic EL elements can be arranged so that the first terminal and the second terminal face each other.

In the embodiment, N (where N is a positive integer equal to or greater than 2) organic EL elements in a first direction and M (where M is a positive integer equal to or greater than 2) organic EL elements in a second direction perpendicular to the first direction may be arranged, and the lighting unit may include: a first lighting unit including J (J≤N) organic EL elements arranged in the first direction; and a second lighting unit including K (K≤M) organic EL elements arranged in the second direction. According to this configuration, the two lighting units, that is, the first lighting unit and the second lighting unit, can be obtained from a single mother board.

In the embodiment, N (where N is a positive integer equal to or greater than 2) organic EL elements in a first direction and M (where M is a positive integer equal to or greater than 2) organic EL elements in a second direction perpendicular to the first direction may be arranged, and the lighting unit may include: a first lighting unit including J (J≤N) organic EL elements arranged in the first direction; and a second lighting unit including K (K≤N) organic EL elements arranged in the first direction and L (L≤M) organic EL elements arranged in the second direction. According to this configuration, the two lighting units, that is, the first lighting unit and the second lighting unit, can be obtained from a single mother board.

According to another aspect of the invention, there is provided a method of manufacturing a lighting device, wherein the lighting unit is obtained by cutting the above-mentioned mother board.

In the method of manufacturing a lighting device according to the aspect of the invention, since a lighting unit is obtained by cutting the mother board in which the lighting unit is constituted therein in advance, it is not necessary to perform an operation of connecting a plurality of organic EL elements. Accordingly, it is possible to easily obtain a lighting unit. As a result, it is possible to easily manufacture a lighting device.

### Advantageous Effects of Invention

According to the aspects of the invention, it is possible to easily obtain a lighting unit.

### Brief Description of Drawings

FIG. 1 is a diagram illustrating an organic EL element constituting a mother board according to an embodiment.
FIG. 2 is a sectional view illustrating a part of a light emitting area of an organic EL element.
FIG. 3 is a diagram illustrating an example of a first lighting unit including organic EL elements.
FIG. 4 is a diagram illustrating an example of a second lighting unit including organic EL elements.
FIG. 5 is a diagram illustrating an example of a third lighting unit including organic EL elements.
FIG. 6 is a diagram illustrating an example of a mother board according to a first embodiment.
FIG. 7 is a diagram illustrating an example of a mother board according to a second embodiment.
FIG. 8 is a diagram illustrating an example of a mother board according to another embodiment.

### Description of Embodiments

Hereinafter, exemplary embodiments of the invention will be described in detail with reference to the accompanying drawings. In description with reference to the drawings, the same or corresponding elements will be referred to by the same reference signs and description thereof will not be repeated.

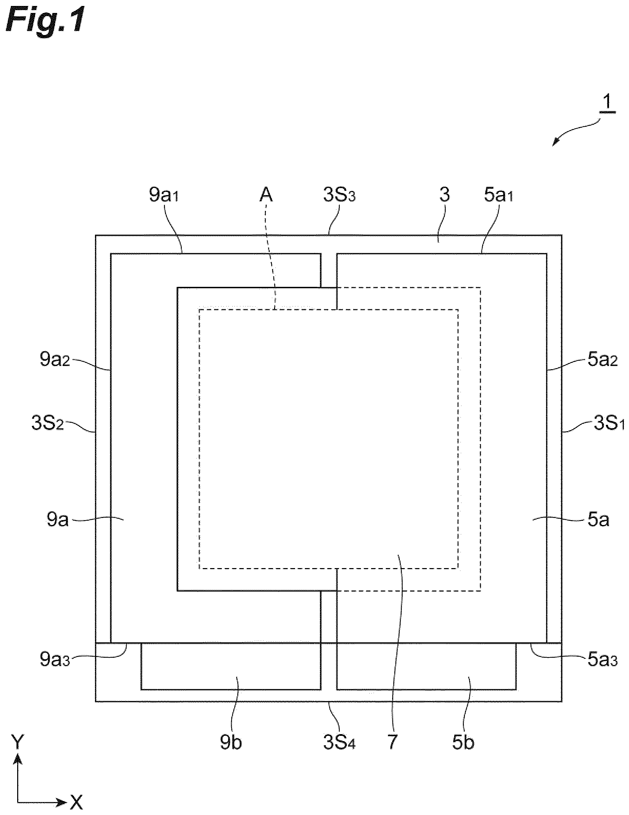

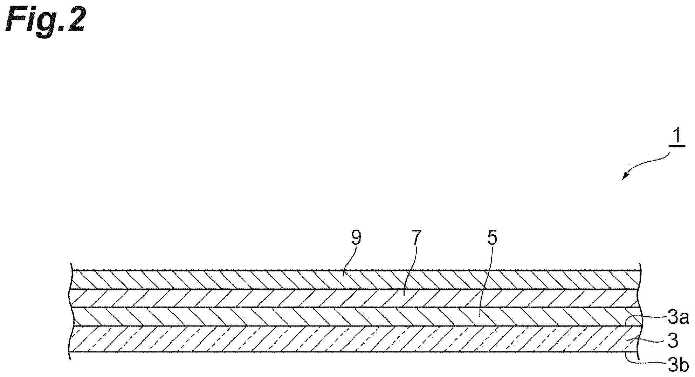

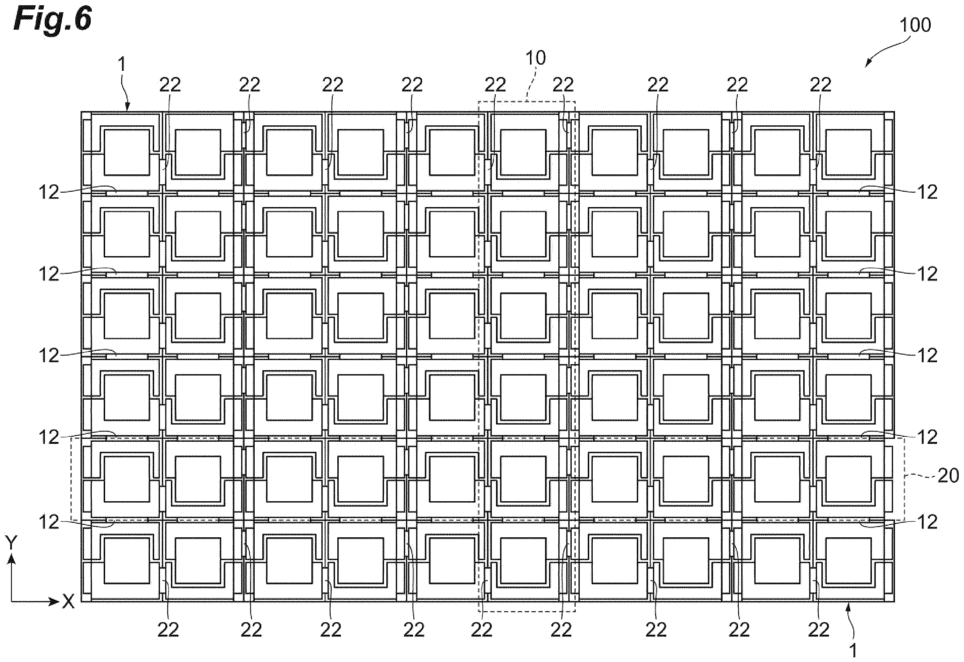

As illustrated in FIGS. 1 and 2, an organic EL element 1 that constitutes a mother board 100 (see FIG. 6) includes a support substrate 3, a positive electrode layer (a first electrode layer) 5, an organic functional layer 7, and a negative electrode layer (a second electrode layer) 9. An area in which the positive electrode layer 5, the organic functional layer 7, and the negative electrode layer 9 overlap serves as a light emitting area A. The light emitting area A has a rectangular shape when seen in a direction in which the positive electrode layer 5, the organic functional layer 7, and the negative electrode layer 9 are stacked (hereinafter simply referred to as a "stacking direction"). The organic EL element 1 includes a sealing layer (not illustrated) that seals the organic functional layer 7 and the negative electrode layer 9. In the following description, a horizontal direction in the drawings is defined as an "X direction" and a vertical direction is defined as a "Y direction."

### [Support substrate]

The support substrate 3 is formed of a resin having a light transmitting property with respect to visible light (light with a wavelength of 400 nm to 800 nm). The support substrate 3 includes a first side 3S₁, a second side 3S₂, a third side 3S₃, and a fourth side 3S₄. The first side 3S₁ and the second side 3S₂ extend substantially in parallel to each other in the Y direction. The third side 3S₃ and the fourth side 3S₄ extend substantially in parallel to each other in the X direction. The support substrate 3 has a rectangular shape.

Examples of the material of the support substrate 3 include polyether sulfone (PES); a polyester resin such as polyethylene terephthalate (PET) or polyethylene naphthalate (PEN); a polyolefin resin such as polyethylene (PE), polypropylene (PP), or a cyclic polyolefin; a polyamide resin; a polycarbonate resin; a polystyrene resin; a polyvinyl alcohol resin; a saponified product of an ethylene vinyl acetate copolymer; a polyacrylonitrile resin; an acetal resin; a polyimide resin; and an epoxy resin.

In view of high heat resistance, a low linear expansion coefficient, and a low manufacturing cost, among the above-mentioned resins, a polyester resin and a polyolefin resin can be preferably used as the material of the support substrate 3, and a polyethylene terephthalate and a polyethylene naphthalate can be particularly preferably used. These resins may be used alone or in a combination of two or more types.

A gas barrier layer may be disposed on one principal surface 3a of the support substrate 3. The other principal surface 3b of the support substrate 3 serves as a light emitting surface. The support substrate 3 may be formed of thin-film glass.

### [Positive electrode layer]

The positive electrode layer 5 is disposed on one principal surface 3a of the support substrate 3. An electrode layer having a light transmitting property is used as the positive electrode layer 5. A thin film of a metal oxide, a metal sulfide, a metal, or the like having high electric conductivity can be used as the electrode layer having a light transmitting property, and a thin film having high light transmittance can be preferably used. For example, a thin film formed of indium oxide, zinc oxide, tin oxide, indium tin oxide (abbreviated to ITO), indium zinc oxide (abbreviated to IZO), gold, platinum, silver, copper, or the like is used, and among these, a thin film formed of ITO, IZO, or tin oxide can be preferably used.

A transparent conductive film of an organic material such as polyaniline and derivatives thereof and polythiophene and derivatives thereof may be used as the positive electrode layer 5. An electrode in which a metal, a metal alloy, or the like is patterned in a mesh shape or an electrode in which nanowires containing silver are formed in a network shape may be used as the positive electrode layer 5.

The thickness of the positive electrode layer 5 can be determined in consideration of light transmitting properties, electric conductivity, and the like. The thickness of the positive electrode layer 5 generally ranges from 10 nm to 10 µm, preferably ranges from 20 nm to 1 µm, and more preferably ranges from 50 nm to 500 nm.

Examples of the method of forming the positive electrode layer 5 include a vacuum vapor deposition method, a sputtering method, an ion plating method, a plating method, and a coating method.

A first positive electrode terminal (a first terminal) 5a and a second positive electrode terminal (a first terminal) 5b are electrically connected to the positive electrode layer 5. The first positive electrode terminal 5a and the second positive electrode terminal 5b are disposed on one principal surface 3a of the support substrate 3. As illustrated in FIG. 1, the first positive electrode terminal 5a and the second positive electrode terminal 5b are disposed in an area on one side (a right side) in the X direction (the horizontal direction) of the support substrate 3. The first positive electrode terminal 5a has substantially a U shape. The first positive electrode terminal 5a has a part which is located close to the first side 3S₁ of the support substrate 3. The first positive electrode terminal 5a has a first side 5a₁ parallel to the third side 3S₃ of the support substrate 3, a second side 5a₂ parallel to the first side 3S₁ of the support substrate 3, and a third side 5a₃ parallel to the fourth side 3S₄ of the support substrate 3.

The second positive electrode terminal 5b is electrically connected to the first positive electrode terminal 5a. The second positive electrode terminal 5b has a rectangular shape. The second positive electrode terminal 5b is disposed close to the fourth side 3S₄ of the support substrate 3 and is connected to the third side 5a₃ of the first positive electrode terminal 5a. The second positive electrode terminal 5b is disposed so that a length direction thereof is parallel to the fourth side 3S₄ of the support substrate 3.

### [Organic functional layer]

The organic functional layer 7 is disposed on the positive electrode layer 5. The organic functional layer 7 includes a light emitting layer. The organic functional layer 7 is mainly formed of an organic material emitting fluorescence and/or phosphorescence or the organic material and a dopant material for a light emitting layer assisting the organic material. For example, the dopant material for a light emitting layer is added to improve emission efficiency or to change an emission wavelength. The organic material may be a low-molecular compound or a high-molecular compound. Examples of a light emitting material of the organic functional layer 7 include pigment-based materials, metal complex-based materials, polymer-based materials, or dopant materials for a light emitting layer.

### (Pigment-based materials)

Examples of the pigment-based materials include cyclopentamine and derivatives thereof, tetraphenyl butadiene and derivatives thereof, triphenyl amine and derivatives thereof, oxadiazole and derivatives thereof, pyrazoloquinoline and derivatives thereof, distyrylbenzene and derivatives thereof, distyrylarylenes and derivatives thereof, pyrrole and derivatives thereof, thiophene compounds, pyridine compounds, perinone and derivatives thereof, perylene and derivatives thereof, oligothiophene and derivatives thereof, oxadiazole dimer and derivatives thereof, pyrazoline dimer and derivatives thereof, quinacridone and derivatives thereof, and coumarin and derivatives thereof.

### (Metal complex-based materials)

Examples of the metal complex-based materials include metal complexes having a rare-earth metal such as Tb, Eu, or Dy or Al, Zn, Be, Pt, or Ir as a center metal and having oxadiazole, thiadiazole, phenyl pyridine, phenyl benzimidazole, or a quinolone structure, or the like as a ligand. Examples of the metal complexes include metal complexes emitting light in a triplet excited state such as iridium complex and platinum complex, aluminum quinolinol complex, benzoquinolinol beryllium complex, benzooxazolyl zinc complex, benzothiazole zinc complex, azomethyl zinc complex, porphyrin zinc complex, and phenanthroline europium complex.

### (Polymer-based materials)

Examples of the polymer-based materials include polyparaphenylene vinylene and derivatives thereof, polythiophene and derivatives thereof, polyparaphenylene and derivatives thereof, polysilane and derivatives thereof, polyacetylene and derivatives thereof, polyfluorene and derivatives thereof, polyvinyl carbazole and derivatives thereof, and materials obtained by polymerizing the pigment-based materials or the metal complex-based materials.

### (Dopant materials for light emitting layer)

Examples of the dopant materials for a light emitting layer include perylene and derivatives thereof, coumarin and derivatives thereof, rubrene and derivatives thereof, quinacridone and derivatives thereof, squarylium and derivatives thereof, porphyrin and derivatives thereof, styryl-based pigments, tetracene and derivatives thereof, pyrazolone and derivatives thereof, decacyclene and derivatives thereof, and phenoxazone and derivatives thereof.

The thickness of the organic functional layer 7 generally ranges from 2 nm to 200 nm. The organic functional layer 7 is formed, for example, by a coating method using a coating liquid (for example, ink) containing the above-mentioned light emitting materials. A solvent of the coating liquid containing a light emitting material is not particularly limited as long as it can dissolve the light emitting material.

### [Negative electrode layer]

The negative electrode layer 9 is formed on the organic functional layer 7. For example, an alkali metal, an alkali earth metal, a transition metal, or a metal belonging to Group 13 of the periodic table can be used as the material of the negative electrode layer 9. Specific examples of the negative electrode layer 9 include metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, alloys of two or more types of these metals, alloys of one or more types of these metals and at least one type of gold, silver, platinum, copper, manganese, titanium, cobalt, nickel, tungsten, and tin, and graphite or graphite intercalation compounds. Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

For example, a transparent conductive electrode formed of a conductive metal oxide and a conductive organic material can be used as the negative electrode layer 9. Specific examples of the conductive metal oxide include indium oxide, zinc oxide, tin oxide, ITO, and IZO, and examples of the conductive organic material include polyaniline and derivatives thereof and polythiophene and derivatives thereof. The negative electrode layer 9 may be formed as a stacked body in which two or more layers are stacked. An electron injection layer may be used as the negative electrode layer 9.

The thickness of the negative electrode layer 9 is set in consideration of electric conductivity and durability. The thickness of the negative electrode layer 9 generally ranges from 10 nm to 10 µm, preferably ranges from 20 nm to 1 µm, and more preferably ranges from 50 nm to 500 nm.

Examples of the method of forming the negative electrode layer 9 include a vacuum vapor deposition method, a sputtering method, a laminating method of thermally compressing a metal sheet, and a coating method.

A first negative electrode terminal (a second terminal) 9a and a second negative electrode terminal (a second terminal) 9b are electrically connected to the negative electrode layer 9. The first negative electrode terminal 9a and the second negative electrode terminal 9b are disposed on one principal surface 3a of the support substrate 3. As illustrated in FIG. 1, the first negative electrode terminal 9a and the second negative electrode terminal 9b are disposed in an area on the other side (a left side) in the X direction (the horizontal direction) of the support substrate 3. The first negative electrode terminal 9a has substantially a U shape. The first negative electrode terminal 9a has a part which is located close to the second side 3S₂ of the support substrate 3. The first negative electrode terminal 9a has a first side 9a₁ parallel to the third side 3S₃ of the support substrate 3, a second side 9a₂ parallel to the second side 3S₂ of the support substrate 3, and a third side 9a₃ parallel to the fourth side 3S₄ of the support substrate 3. The first negative electrode terminal 9a is disposed to face the first positive electrode terminal 5a in the X direction on the side close to the third side 3S₃ of the support substrate 3.

The second negative electrode terminal 9b is electrically connected to the first negative electrode terminal 9a. The second negative electrode terminal 9b has a rectangular shape. The second negative electrode terminal 9b is disposed close to the fourth side 3S₄ of the support substrate 3 and is connected to the third side 9a₃ of the first negative electrode terminal 9a. The second negative electrode terminal 9b is disposed so that a length direction thereof is parallel to the fourth side 3S₄ of the support substrate 3. The second negative electrode terminal 9b is disposed to face the second positive electrode terminal 5b in the X direction.

### [Lighting units]

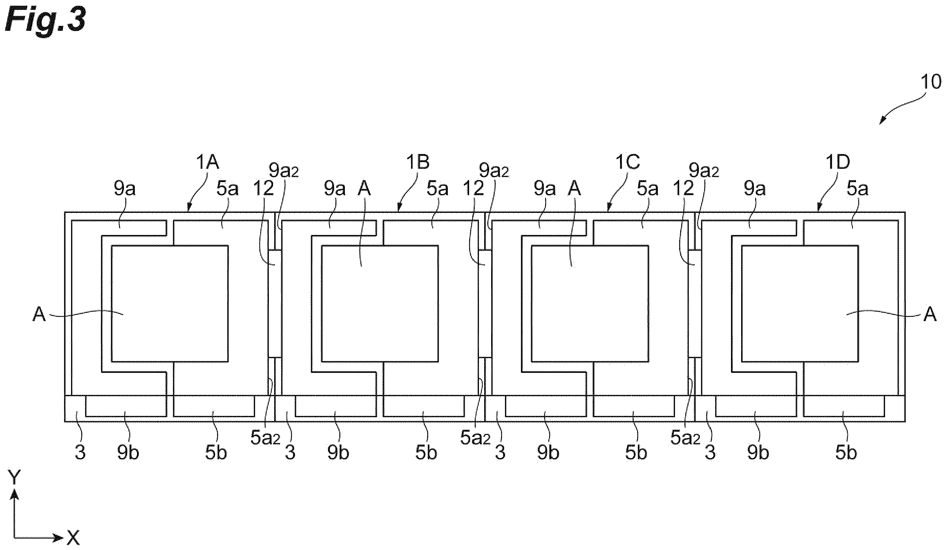

Lighting units will be described next. A first lighting unit 10, a second lighting unit 20, and a third lighting unit 30 will be described below with reference to FIGS. 3 to 5.

### (First lighting unit)

The first lighting unit 10 has a configuration in which a plurality of organic EL elements 1 are electrically connected to each other. As illustrated in FIG. 3, the first lighting unit 10 has a configuration in which a plurality of (here, four) organic EL elements 1A to 1D are connected to each other. Specifically, in the first lighting unit 10, the second side 5a₂ of the first positive electrode terminal 5a of the organic EL element 1A and the second side 9a₂ of the first negative electrode terminal 9a of the organic EL element 1B are disposed to face each other. In the first lighting unit 10, the second side 5a₂ of the first positive electrode terminal 5a of the organic EL element 1B and the second side 9a₂ of the first negative electrode terminal 9a of the organic EL element 1C are disposed to face each other. In the first lighting unit 10, the second side 5a₂ of the first positive electrode terminal 5a of the organic EL element 1C and the second side 9a₂ of the first negative electrode terminal 9a of the organic EL element 1D are disposed to face each other.

In the first lighting unit 10, the second side 5a₂ of the first positive electrode terminal 5a of the organic EL element 1A and the second side 9a₂ of the first negative electrode terminal 9a of the organic EL element 1B are electrically connected by a connecting member 12. Similarly, in the first lighting unit 10, the second side 5a₂ of the first positive electrode terminal 5a of the organic EL element 1B and the second side 9a₂ of the first negative electrode terminal 9a of the organic EL element 1C are electrically connected by a connecting member 12, and the second side 5a₂ of the first positive electrode terminal 5a of the organic EL element 1C and the second side 9a₂ of the first negative electrode terminal 9a of the organic EL element 1D are electrically connected by a connecting member 12. Accordingly, in the first lighting unit 10, the plurality of organic EL elements 1A to 1D are connected in series.

The connecting member 12 is formed of a material having high electric conductivity. A metal oxide, a metal sulfide, a metal, or the like having high electric conductivity can be used as the material of the connecting member 12. In this embodiment, the connecting member 12 is formed in a belt shape and is formed at the same time as the positive electrode layer 5. The connecting member 12 has only to electrically connect terminals and may be, for example, a wire.

In the first lighting unit 10, the light emitting areas A of the organic EL elements 1A to 1D emit light, for example, when a voltage is applied to the first negative electrode terminal 9a of the organic EL element 1A and the first positive electrode terminal 5a of the organic EL element 1D.

### (Second lighting unit)

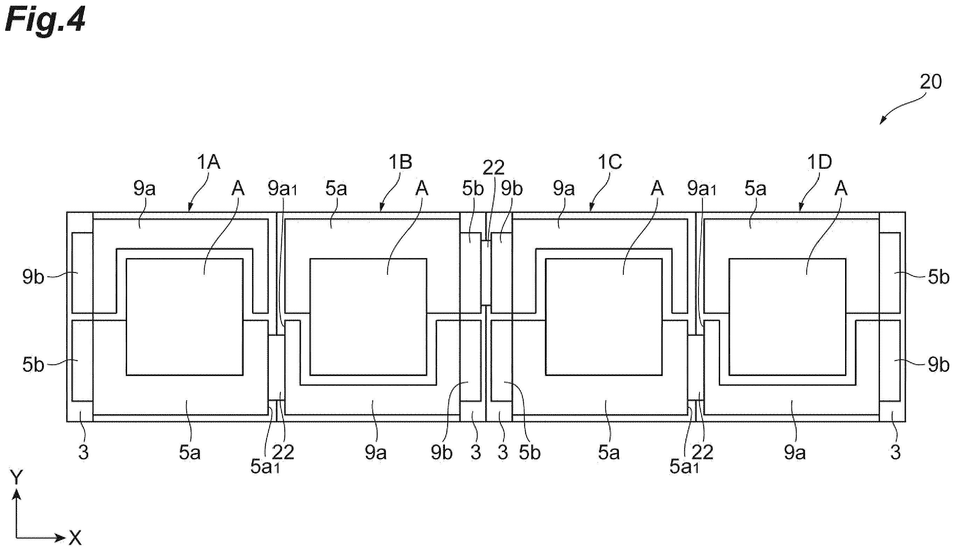

As illustrated in FIG. 4, the second lighting unit 20 has a configuration in which a plurality of (here, four) organic EL elements 1A to 1D are connected to each other. Specifically, in the second lighting unit 20, the first side 5a₁ of the first positive electrode terminal 5a and the first side 9a₁ of the first negative electrode terminal 9a of the organic EL element 1A and the first side 9a₁ of the first negative electrode terminal 9a and the first side 5a₁ of the first positive electrode terminal 5a of the organic EL element 1B are disposed to face each other. In the second lighting unit 20, the second positive electrode terminal 5b and the second negative electrode terminal 9b of the organic EL element 1B and the second positive electrode terminal 5b and the second negative electrode terminal 9b of the organic EL element 1C are disposed to face each other. In the second lighting unit 20, the first side 5a₁ of the first positive electrode terminal 5a and the first side 9a₁ of the first negative electrode terminal 9a of the organic EL element 1A and the first side 9a₁ of the first negative electrode terminal 9a and the first side 5a₁ of the first positive electrode terminal 5a of the organic EL element 1B are disposed to face each other.

In the second lighting unit 20, the first side 5a₁ of the first positive electrode terminal 5a of the organic EL element 1A and the first side 9a₁ of the first negative electrode terminal 9a of the organic EL element 1B are electrically connected by a connecting member 22. Similarly, in the second lighting unit 20, the second positive electrode terminal 5b of the organic EL element 1B and the second negative electrode terminal 9b of the organic EL element 1C are electrically connected by a connecting member 22, and the first side 5a₁ of the first positive electrode terminal 5a of the organic EL element 1C and the first side 9a₁ of the first negative electrode terminal 9a of the organic EL element 1D are electrically connected by a connecting member 22. Accordingly, in the second lighting unit 20, the plurality of organic EL elements 1A to 1D are connected in series. The connecting member 22 has the same configuration as the connecting member 12 illustrated in FIG. 3.

In the second lighting unit 20, the light emitting areas A of the organic EL elements 1A to 1D emit light, for example, when a voltage is applied to the second negative electrode terminal 9b of the organic EL element 1A and the second positive electrode terminal 5b of the organic EL element 1D.

### (Third lighting unit)

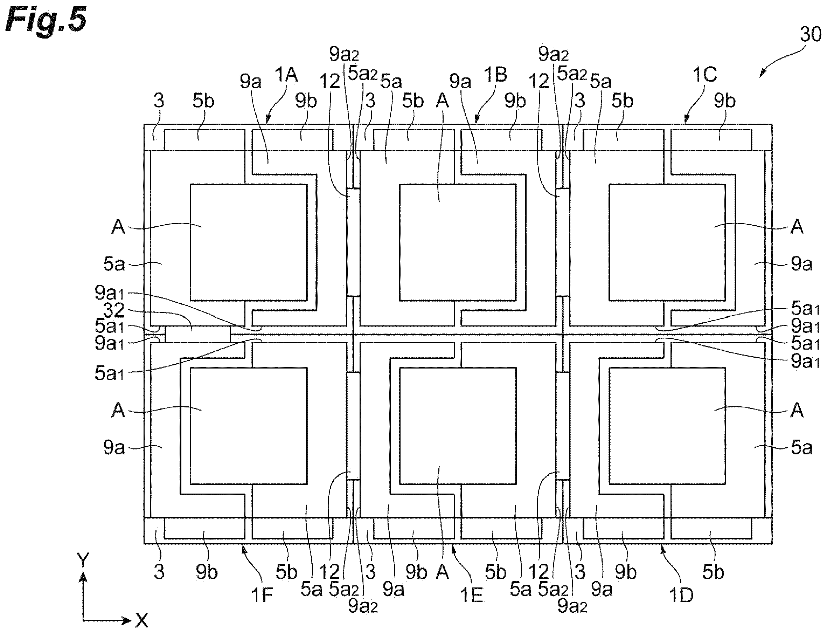

As illustrated in FIG. 5, the third lighting unit 30 has a configuration in which a plurality of (here, six) organic EL elements 1A to 1F are connected to each other. Specifically, in the third lighting unit 30, the second side 9a₂ of the first negative electrode terminal 9a of the organic EL element 1A and the second side 5a₂ of the first positive electrode terminal 5a of the organic EL element 1B are disposed to face each other in the X direction, and the first side 5a₁ of the first positive electrode terminal 5a and the first side 9a₁ of the first negative electrode terminal 9a of the organic EL element 1A and the first side 9a₁ of the first negative electrode terminal 9a and the first side 5a₁ of the first positive electrode terminal 5a of the organic EL element IF are disposed to face each other in the Y direction. In the third lighting unit 30, the second side 9a₂ of the first negative electrode terminal 9a of the organic EL element 1B and the second side 5a₂ of the first positive electrode terminal 5a of the organic EL element 1C are disposed to face each other in the X direction, and the first side 5a₁ of the first positive electrode terminal 5a and the first side 9a₁ of the first negative electrode terminal 9a of the organic EL element 1B and the first side 9a₁ of the first negative electrode terminal 9a and the first side 5a₁ of the first positive electrode terminal 5a of the organic EL element 1E are disposed to face each other in the Y direction.

In the third lighting unit 30, the first side 5a₁ of the first positive electrode terminal 5a and the first side 9a₁ of the first negative electrode terminal 9a of the organic EL element 1C and the first side 9a₁ of the first negative electrode terminal 9a and the first side 5a₁ of the first positive electrode terminal 5a of the organic EL element 1D are disposed to face each other in the Y direction. In the third lighting unit 30, the second side 9a₂ of the first negative electrode terminal 9a of the organic EL element 1D and the second side 5a₂ of the first positive electrode terminal 5a of the organic EL element 1E are disposed to face each other in the X direction. In the third lighting unit 30, the second side 9a₂ of the first negative electrode terminal 9a of the organic EL element IE and the second side 5a₂ of the first positive electrode terminal 5a of the organic EL element IF are disposed to face each other.

In the third lighting unit 30, the second side 9a₂ of the first negative electrode terminal 9a of the organic EL element 1A and the second side 5a₂ of the first positive electrode terminal 5a of the organic EL element 1B are electrically connected by a connecting member 12. In the third lighting unit 30, the first side 5a₁ of the first positive electrode terminal 5a of the organic EL element 1A and the first side 9a₁ of the first negative electrode terminal 9a of the organic EL element 1F are electrically connected by a connecting member 32. In the third lighting unit 30, the second side 9a₂ of the first negative electrode terminal 9a of the organic EL element 1B and the second side 5a₂ of the first positive electrode terminal 5a of the organic EL element 1C are electrically connected by a connecting member 12.

In the third lighting unit 30, the second side 9a₂ of the first negative electrode terminal 9a of the organic EL element 1D and the second side 5a₂ of the first positive electrode terminal 5a of the organic EL element IE are electrically connected by a connecting member 12. In the third lighting unit 30, the second side 9a₂ of the first negative electrode terminal 9a of the organic EL element IE and the second side 5a₂ of the first positive electrode terminal 5a of the organic EL element IF are electrically connected by a connecting member 12. Accordingly, in the third lighting unit 30, the plurality of organic EL elements 1A to 1F are connected in series.

In the third lighting unit 30, the light emitting areas A of the organic EL elements 1A to 1F emit light, for example, when a voltage is applied to the first negative electrode terminal 9a of the organic EL element 1C and the first positive electrode terminal 5a of the organic EL element 1D.

### [Mother board]

### (First embodiment)

The mother board will be described below. As illustrated in FIG. 6, N (where N is an integer equal to or greater than 2) organic EL elements 1 in the X direction (a first direction) and M (where M is an integer equal to or greater than 2) organic EL elements 1 in the X direction (a second direction) which is perpendicular to the X direction are arranged on a mother board 100 according to a first embodiment. In this embodiment, six organic EL elements 1 in the Y direction and ten organic EL elements 1 in the X direction are arranged. The organic EL elements 1 disposed on the mother board 100 can emit light independently.

The mother board 100 includes the first lighting unit 10 and the second lighting unit 20. The first lighting unit 10 includes J (J≤N) organic EL elements 1 which are arranged in the Y direction. In the example illustrated in FIG. 6, the first lighting unit 10 includes six organic EL elements 1. The second lighting unit 20 includes K (K≤M) organic EL elements 1 which are arranged in the X direction. In the example illustrated in FIG. 6, the second lighting unit 20 includes ten organic EL elements 1.

In the method of manufacturing a lighting device, the first lighting unit 10 or the second lighting unit 20 is cut out of the mother board 100 having the above-mentioned configuration. When the first lighting unit 10 is cut out of the mother board 100, the mother board 100 is cut in the Y direction so that the connecting members 22 are cut off. When the second lighting unit 20 is cut out of the mother board 100, the mother board 100 is cut in the X direction so that the connecting members 12 are cut off. In the first lighting unit 10 or the second lighting unit 20 which are cut out of the mother board 100, the light emitting areas A of the individual organic EL elements 1 emit light when a voltage is applied.

As described above, in the mother board 100 according to the first embodiment, neighboring organic EL elements 1 are disposed so that the first positive electrode terminal 5a or the second positive electrode terminal 5b and the first negative electrode terminal 9a or the second negative electrode terminal 9b face each other. In this configuration, a predetermined first positive electrode terminal 5a or a predetermined second positive electrode terminal 5b and a predetermined first negative electrode terminal 9a or a predetermined second negative electrode terminal 9b are electrically connected by the connecting member 12 or 22, and the first lighting unit 10 and the second lighting unit 20 are constituted by a plurality of organic EL elements 1. In this way, since the first lighting unit 10 and the second lighting unit 20 including organic EL elements 1 that can individually emit light are configured in advance in the mother board 100, it is possible to obtain the first lighting unit 10 or the second lighting unit 20 by cutting the mother board 100. Accordingly, since an operation of connecting a plurality of organic EL elements 1 does not need to be performed, it is possible to easily obtain the first lighting unit 10 or the second lighting unit 20.

### (Second embodiment)

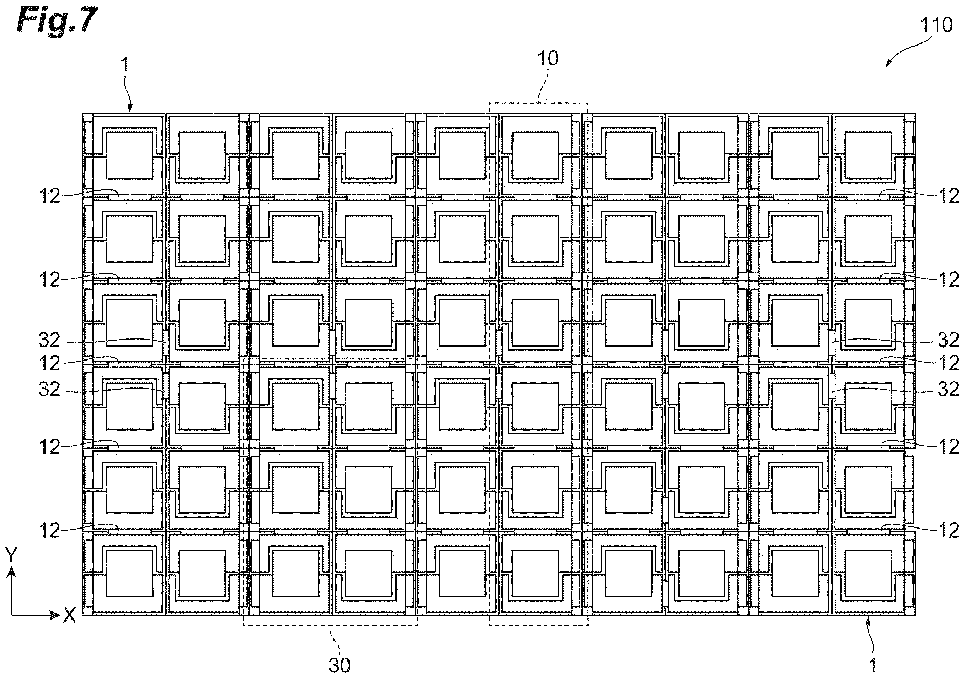

As illustrated in FIG. 7, N (where N is an integer equal to or greater than 2) organic EL elements 1 in the X direction and M (where M is an integer equal to or greater than 2) organic EL elements 1 in the Y direction which is perpendicular to the X direction are arranged on a mother board 110 according to a second embodiment. In this embodiment, six organic EL elements 1 in the Y direction and ten organic EL elements 1 in the X are arranged. The organic EL elements 1 disposed on the mother board 110 can emit light independently.

The mother board 110 includes the first lighting unit 10 and the third lighting unit (the second lighting unit) 30. The first lighting unit 10 includes J (J≤N) organic EL elements 1 which are arranged in the Y direction. In the example illustrated in FIG. 7, the first lighting unit 10 includes six organic EL elements 1. The third lighting unit 30 includes K (K≤N) organic EL elements 1 which are arranged in the Y direction and L (L≤M) organic EL elements 1 which are arranged in the X direction. In the example illustrated in FIG. 7, the third lighting unit 30 includes three organic EL elements 1 in the Y direction and two organic EL elements 1 in the X direction.

In the method of manufacturing a lighting device, the first lighting unit 10 or the third lighting unit 30 is cut out of the mother board 110 having the above-mentioned configuration. When the first lighting unit 10 is cut out of the mother board 110, the mother board 110 is cut in the Y direction so that the connecting members 22 are cut off. When the third lighting unit 30 is cut out of the mother board 110, the mother board 110 is cut in the X direction and the mother board 110 is cut in the Y direction so that the connecting members 12 are cut off. In the first lighting unit 10 or the third lighting unit 30 which are cut out of the mother board 110, the light emitting areas A of the individual organic EL elements 1 emit light when a voltage is applied.

As described above, in the mother board 110 according to the second embodiment, neighboring organic EL elements 1 are disposed so that the first positive electrode terminal 5a or the second positive electrode terminal 5b and the first negative electrode terminal 9a or the second negative electrode terminal 9b face each other. In this configuration, a predetermined first positive electrode terminal 5a or a predetermined second positive electrode terminal 5b and a predetermined first negative electrode terminal 9a or a predetermined second negative electrode terminal 9b are electrically connected by the connecting member 12 or 32, and the first lighting unit 10 and the third lighting unit 30 are constituted by a plurality of organic EL elements 1. In this way, since the first lighting unit 10 and the third lighting unit 30 including organic EL elements that can individually emit light are configured in advance in the mother board 110, it is possible to obtain the first lighting unit 10 or the third lighting unit 30 by cutting the mother board 110. Accordingly, since an operation of connecting a plurality of organic EL elements 1 does not need to be performed, it is possible to easily obtain the first lighting unit 10 or the third lighting unit 30.

The invention is not limited to the above-mentioned embodiments and can be modified in various forms. For example, in the embodiment, an organic EL element 1 in which the organic functional layer 7 including a light emitting layer is disposed between the positive electrode layer 5 and the negative electrode layer 9 has been described. However, the configuration of the organic functional layer 7 is not limited thereto. The organic functional layer 7 may have the following configurations.
(a) (positive electrode layer)/light emitting layer/(negative electrode layer)
(b) (positive electrode layer)/hole injection layer/light emitting layer/(negative electrode layer)
(c) (positive electrode layer)/hole injection layer/light emitting layer/electron injection layer/(negative electrode layer)
(d) (positive electrode layer)/hole injection layer/light emitting layer/electron transport layer/electron injection layer/(negative electrode layer)
(e) (positive electrode layer)/hole injection layer/hole transport layer/light emitting layer/(negative electrode layer)
(f) (positive electrode layer)/hole injection layer/hole transport layer/light emitting layer/electron injection layer/(negative electrode layer)
(g) (positive electrode layer)/hole injection layer/hole transport layer/light emitting layer/electron transport layer/electron injection layer/(negative electrode layer)
(h) (positive electrode layer)/light emitting layer/electron injection layer/(negative electrode layer)
(i) (positive electrode layer)/light emitting layer/electron injection layer/electron injection layer/(negative electrode layer)

Here, the symbol "/" means that layers described before and after the symbol "/" are stacked adjacent to each other. The configuration described in (a) is the configuration of the organic EL element 1 according to the above-mentioned embodiments.

Known materials can be used as the materials of a hole injection layer, a hole transport layer, an electron transport layer, and an electron injection layer. The hole injection layer, the hole transport layer, the electron transport layer, and the electron injection layer can be formed, for example, using a similar coating method to the organic functional layer 7.

The organic EL element 1 may have a single organic functional layer 7 or may have two or more organic functional layers 7. In any one of the layer configurations (a) to (i), when a stacked structure which is disposed between the positive electrode layer 5 and the negative electrode layer 9 is defined as "structure unit A," a layer configuration described below in (j) can be exemplified as the configuration of the organic EL element including two light emitting layers 7. The layer configurations of two (Structure units A) may be the same as or different from each other.
(j) positive electrode layer/(structure unit A)/charge generation layer/(structure unit A)/negative electrode layer

Here, the charge generation layer is a layer that generates holes and electrons when an electric field is applied. Examples of the charge generation layer include thin films formed of vanadium oxide, ITO, or molybdenum oxide.

When "(structure unit A)/charge generation layer" is defined as "structure unit B," a layer configuration described below in (k) can be exemplified as the configuration of the organic EL element including three or more organic functional layers 7.
(k) positive electrode layer/(structure unit B)ₓ/(structure unit A)/negative electrode layer

The symbol "x" denotes an integer which is equal to or greater than 2, and "(structure unit B)ₓ" denotes a stacked body in which x stages of (structure unit B) are stacked. The layer configurations of (Structure units B) may be the same or may be different from each other.

The organic EL element may be constituted by directly stacking a plurality of organic functional layers 7 instead of forming the charge generating layer.

In the above-mentioned embodiments, an example in which the first lighting unit 10 and the second lighting unit 20 are formed in the mother board 100 has been described. However, only one of the first lighting unit 10 and the second lighting unit 20 has to be formed in the mother board 100. Similarly, only one of the first lighting unit 10 and the third lighting unit 30 has to be formed in the mother board 110.

In the above-mentioned embodiments, an example in which the third lighting unit 30 formed in the mother board 110 includes three organic EL elements 1 in the Y direction and two organic EL elements 1 in the X direction has been described. However, the configuration of the third lighting unit 30 is not limited thereto. For example, the third lighting unit 30 may include three organic EL elements 1 in the Y direction and three organic EL elements 1 in the X direction. In this case, only predetermined ones of the terminals have to be electrically connected to each other by the connecting member 32.

In the above-mentioned embodiments, examples in which the first lighting unit 10 and the second lighting unit 20 are formed in the mother board 100 and the first lighting unit 10 and the third lighting unit 30 are formed in the mother board 110 have been described. However, the lighting units formed in the mother board are not limited thereto.

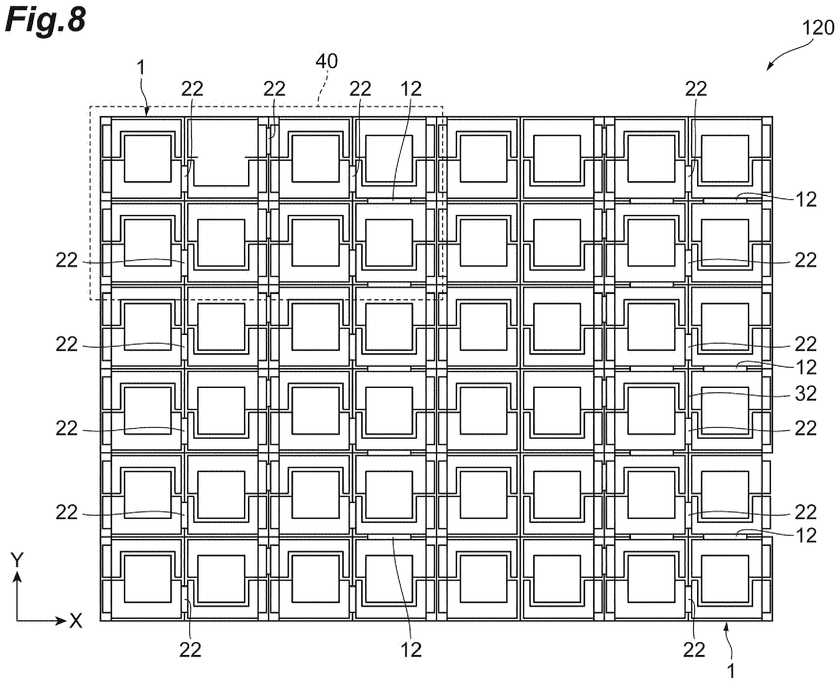

For example, as illustrated in FIG. 8, a fourth lighting unit 40 may be formed in a mother board 120. The fourth lighting unit 40 includes two organic EL elements 1 in the Y direction and four organic EL elements 1 in the X direction. In the fourth lighting unit 40, a plurality of organic EL elements 1 are connected in series by electrically connecting the plurality of organic EL elements 1 using the connecting members 12 and 22.

### Reference Signs List

1 Organic EL element
3 Support substrate
3S₁ First side
3S₂ Second side
3S₃ Third side
3S₄ Fourth side
5 Positive electrode layer (first electrode layer)
5a First positive electrode terminal
5b Second positive electrode terminal
7 Organic functional layer
9 Negative electrode layer (second electrode layer)
9a First negative electrode terminal
9b Second negative electrode terminal
10 First lighting unit
20 Second lighting unit
30 Third lighting unit (second lighting unit)
40 Fourth lighting unit
12, 22, 32 Connecting member
100, 110, 120 Mother board

## Claims

1. A mother board comprising a plurality of organic EL elements,
wherein each of the plurality of organic EL elements has a configuration in which a first electrode layer, an organic functional layer, and a second electrode layer are sequentially stacked on a rectangular support substrate having a first side and a second side extending substantially in parallel to each other and a third side and a fourth side extending substantially in parallel to each other,
wherein each of the plurality of organic EL elements includes a first terminal that is electrically connected to the first electrode layer and a second terminal that is electrically connected to the second electrode layer,
wherein neighboring organic EL elements are arranged so that the first terminal and the second terminal face each other, and
wherein predetermined ones of the first terminals and the second terminals are electrically connected to each other by a connecting member so that the plurality of organic EL elements constitute a lighting unit.

2. The mother board according to claim 1, wherein the first terminal is disposed close to the first side and the second terminal is disposed close to the second side.

3. The mother board according to claim 1 or 2, wherein the first terminal is disposed close to the third side and the fourth side,
wherein the second terminal is disposed close to the third side and the fourth side, and
wherein the first terminal and the second terminal are disposed to face each other in a direction in which the third side and the fourth side extend at positions close to the third side and the fourth side.

4. The mother board according to any one of claims 1 to 3, wherein N (where N is a positive integer equal to or greater than 2) organic EL elements in a first direction and M (where M is a positive integer equal to or greater than 2) organic EL elements in a second direction perpendicular to the first direction are arranged, and
wherein the lighting unit includes:
a first lighting unit including J (J≤N) organic EL elements arranged in the first direction; and
a second lighting unit including K (K≤M) organic EL elements arranged in the second direction.

5. The mother board according to any one of claims 1 to 3, wherein N (where N is a positive integer equal to or greater than 2) organic EL elements in a first direction and M (where M is a positive integer equal to or greater than 2) organic EL elements in a second direction perpendicular to the first direction are arranged, and
wherein the lighting unit includes:
a first lighting unit including J (J≤N) organic EL elements arranged in the first direction; and
a second lighting unit including K (K≤N) organic EL elements arranged in the first direction and L (L≤M) organic EL elements arranged in the second direction.

6. A method of manufacturing a lighting device, wherein the lighting unit is obtained by cutting the mother board according to any one of claims 1 to 5.
